# EUROPEAN PATENT APPLICATION

(11) **EP 4 564 419 A2**
(43) Date of publication of application: **04.06.2025**
(21) Application number: 24212450.1
(22) Date of filing: 12.11.2024
(51) Int. Cl.: H01L 23/31, H01L 23/373, H01L 23/498, H01L 23/00, H01L 25/07

(54) **POWER MODULE**

(30) Priority: 13.11.2023 CN 202311504356
(71) Applicant: Delta Electronics, Inc., Taoyuan City 33341 (TW)
(72) Inventor: CHEN, Jung-Li, Taoyuan City (TW); TSAI, Yu-Hsuan, Taoyuan City (TW); TSAI, Chang-Chin, Taoyuan City (TW); CHIANG, Hsin-Chun, Taoyuan City (TW)
(74) Representative: 2K Patentanwälte Blasberg Kewitz & Reichel

(57) **Abstract**

A power module is provided. The power module includes a substrate, a semiconductor component, a plurality of pins and a package. The substrate has a first metal surface. The semiconductor component is disposed on the first metal surface. The plurality of pins extends from the first metal surface and is configured to be electrically connected to the semiconductor component. The package body is configured to cover the first metal surface and the semiconductor component, and the package body partially encloses each of the pins. There is a gap between each two adjacent pins, and a separating element is disposed in each gap to increase a creepage distance between the two adjacent pins.

## Description

### CROSS REFERENCE TO RELATED APPLICATIONS

This application claims the benefit of China Patent Application No. 202311504356.4, filed on November 13, 2023, the entirety of which is incorporated by reference herein.

### BACKGROUND OF THE INVENTION

### Field of the Disclosure

The present disclosure relates to a power module, and in particular it relates to a power module that can reduce the volume.

### Description of the Related Art

With the development of science and technology, many power modules are now quite popular and popular products.

Generally speaking, a power module has a plurality of pins for signal transmission. However, in order to comply with safety regulations, the distance between adjacent pins is limited, making it very hard to reduce the overall size of the power module.

Therefore, how to design a power module that can be reduced in size and comply with safety regulations are topics nowadays that need to be discussed and solved.

### BRIEF SUMMARY OF THE INVENTION

Accordingly, one objective of the present disclosure is to provide a power module to solve the above problems.

According to some embodiments of the disclosure, a power module is provided. The power module includes a substrate, a semiconductor component, a plurality of pins and a package body. The substrate has a first metal surface. The semiconductor component is disposed on the first metal surface. The plurality of pins extend from the first metal surface and are configured to be electrically connected to the semiconductor component. The package body is configured to cover the first metal surface and the semiconductor component, and the package body partially encloses each of the pins. There is a gap between each two adjacent pins, and a separating element is disposed in each gap to increase the creepage distance between two adjacent pins.

According to some embodiments, the plurality of pins extends along a first axis, and when viewed along the first axis, the plurality of pins are arranged in a matrix.

According to some embodiments, when viewed along the first axis, the separating elements include a plurality of first separating elements, each of the first separating elements has a strip-shaped structure which extends along a second axis, and the second axis is perpendicular to the first axis.

According to some embodiments, when viewed along the first axis, the separating elements further include a plurality of second separating elements, each of the second separating elements has a strip-shaped structure which extends along a third axis, and the third axis is perpendicular to the first axis and the second axis.

According to some embodiments, the first separating elements are connected to the second separating elements, and the first separating elements and the second separating elements are staggered with each other.

According to some embodiments, each of the first separating elements is a protruding structure or a concave structure, and each of the second separating elements is a protruding structure or a concave structure.

According to some embodiments, the width of the protruding structure or the concave structure is greater than or equal to 1 mm.

According to some embodiments, the package body is further provided with four third separating elements, and when viewed along the first axis, the four third separating elements form a rectangle which surrounds the pins, the first separating elements and the second separating elements.

According to some embodiments, the first separating elements, the second separating elements and the third separating elements are made of elastic materials, and the material of the package body is different from the materials of the first separating elements, the second separating elements and the third separating elements.

According to some embodiments, each of the third separating elements is another protruding structure or another concave structure, and the width of each of the third separating elements is greater than or equal to 1 mm.

According to some embodiments, the substrate further has a second metal surface configured to dissipate heat generated by the power module to the external environment, wherein the first metal surface and the second metal surface are located on opposite sides of the substrate, and a portion of the second metal surface is exposed from the package body.

According to some embodiments, a power module is provided and includes a substrate, a semiconductor component, a plurality of pins, a package, and a first separating element. The substrate has a first metal surface. The semiconductor component is disposed on the first metal surface. The plurality of pins extends from the first metal surface and is configured to be electrically connected to the semiconductor component. The package body is configured to cover the first metal surface and the semiconductor component, and the package body partially encloses each of the pins. The first separating element is disposed on the package body and surrounds the pins.

According to some embodiments, the pins extend along a first axis, and when viewed along the first axis, the first separating element has two first strip-shaped portions and two second strip-shaped portions, the two first strip-shaped portions extend along a second axis, and the two second strip-shaped portions extend along a third axis, where the first axis, the second axis and the third axis are perpendicular to each other.

According to some embodiments, each of the two first strip-shaped portions and the two second strip-shaped portions is a protruding structure or a concave structure.

According to some embodiments, the power module further includes a second separating element which is disposed on one side of the first separating element, and the second separating element extends along the second axis.

According to some embodiments, the width of each first separating element and each second separating element is greater than 1 mm, and the distance between the second separating element and the first separating element is greater than 1 mm.

According to some embodiments, the power module further includes a third separating element, the second separating element is located between the first separating element and the third separating element, and the third separating element extends along the second axis.

According to some embodiments, the width of the third separating element is greater than 1 mm, and the distance between the third separating element and the second separating element is greater than 1 mm.

According to some embodiments, the second separating element and the third separating element are each a protruding structure or a concave structure, and the width of the second separating element is different from the width of the third separating element.

According to some embodiments, the first separating element, the second separating element and the third separating element are made of elastic materials.

The present disclosure provides a power module having a substrate, a plurality of pins and a package body. There is a gap between each two adjacent pins, and at least one separating element can be disposed in each gap to increase the creepage distance between two adjacent pins. The separating element can be a protruding structure or a concave structure, and the height and width of the protruding structure or the concave structure are greater than or equal to 1 mm.

Therefore, based on the design of the present disclosure, not only can the power module comply with safety regulations, but also the distance between two adjacent pins can be shortened, thereby reducing the overall size of the power module. In addition, the separating element can be made of elastic materials, so that when the power module is connected to an external connector, the protruding separating element can serve as a buffering portion to prevent the power module from being damaged due to the excessive impact force.

Additional features and advantages of the disclosure will be set forth in the description which follows, and, in part, will be obvious from the description, or can be learned by practice of the principles disclosed herein. The features and advantages of the disclosure can be realized and obtained by means of the instruments and combinations pointed out in the appended claims. These and other features of the disclosure will become more fully apparent from the following description and appended claims, or can be learned by the practice of the principles set forth herein.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1 is a three-dimensional schematic diagram of a power module 100 according to an embodiment of the present disclosure.
FIG. 2 is a cross-sectional view of the power module 100 along the line A-A in FIG. 1 according to an embodiment of the present disclosure.
FIG. 3 is a simplified top view of the power module 100 according to an embodiment of the present disclosure.
FIG. 4 is a cross-sectional view of the power module 100 along line B-B in FIG. 3 according to an embodiment of the present disclosure.
FIG. 5 is a schematic cross-sectional view of the power module 100 according to another embodiment of the present disclosure.
FIG. 6 and FIG. 7 are schematic cross-sectional views of simplified partial structures of a power module 100A according to different embodiments of the present disclosure.
FIG. 8 is a simplified top view of a power module 100B according to another embodiment of the present disclosure.
FIG. 9 is a schematic cross-sectional view of the power module 100B along line segment C-C in FIG. 8 according to another embodiment of the present disclosure.
FIG. 10 is a schematic cross-sectional view of the power module 100B according to another embodiment of the present disclosure.
FIG. 11 is a simplified top view of a power module 100C according to another embodiment of the present disclosure.
FIG. 12 is a schematic cross-sectional view of the power module 100C along line D-D in FIG. 11 according to another embodiment of the present disclosure.
FIG. 13 is a schematic cross-sectional view of the power module 100C according to another embodiment of the present disclosure.
FIG. 14 is a simplified top view of a power module 100D according to another embodiment of the present disclosure.
FIG. 15 is a schematic cross-sectional view of the power module 100D along line E-E in FIG. 14 according to another embodiment of the present disclosure.
FIG. 16 is a schematic cross-sectional view of the power module 100D according to another embodiment of the present disclosure.

### DETAILED DESCRIPTION OF THE INVENTION

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are in direct contact, and may also include embodiments in which additional features may be disposed between the first and second features, such that the first and second features may not be in direct contact.

In addition, the present disclosure may repeat reference numerals and/or letters in the various examples. This repetition is for the purpose of simplicity and clarity and does not in itself dictate a relationship between the various embodiments and/or configurations discussed. Moreover, the formation of a feature on, connected to, and/or coupled to another feature in the present disclosure that follows may include embodiments in which the features are in direct contact, and may also include embodiments in which additional features may be disposed interposing the features, such that the features may not be in direct contact. In addition, spatially relative terms, for example, "vertical," "above," "over," "below,", "bottom," etc. as well as derivatives thereof (e.g., "downwardly," "upwardly," etc.) are used in the present disclosure for ease of description of one feature's relationship to another feature. The spatially relative terms are intended to cover different orientations of the device, including the features.

Unless defined otherwise, all technical and scientific terms used herein have the same meaning as commonly understood by one of ordinary skill in the art to which this disclosure belongs. It should be appreciated that each term, which is defined in a commonly used dictionary, should be interpreted as having a meaning conforming to the relative skills and the background or the context of the present disclosure, and should not be interpreted in an idealized or overly formal manner unless defined otherwise.

Use of ordinal terms such as "first", "second", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

In addition, in some embodiments of the present disclosure, terms concerning attachments, coupling and the like, such as "connected" and "interconnected", refer to a relationship wherein structures are secured or attached to one another either directly or indirectly through intervening structures, as well as both movable or rigid attachments or relationships, unless expressly described otherwise.

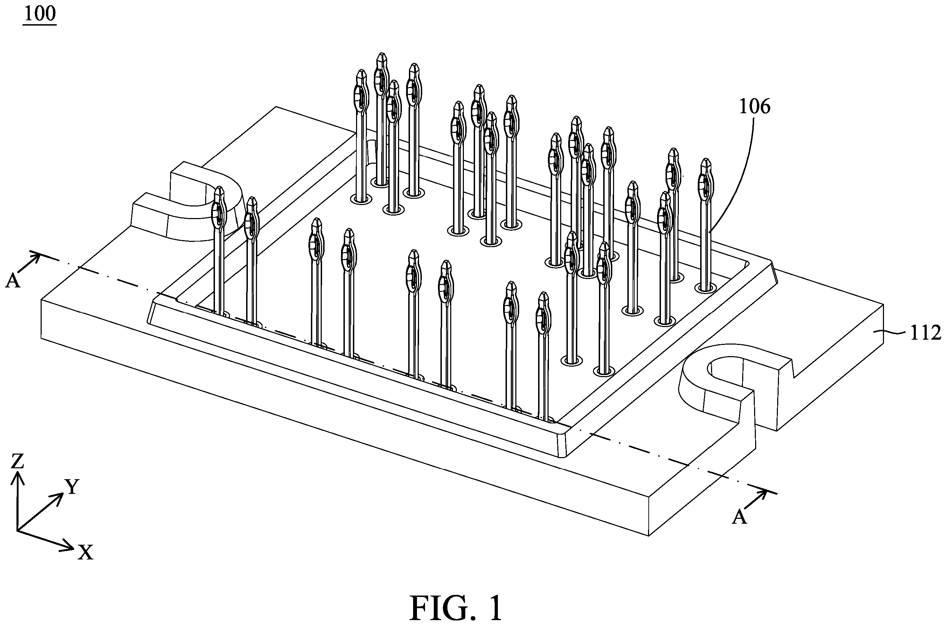

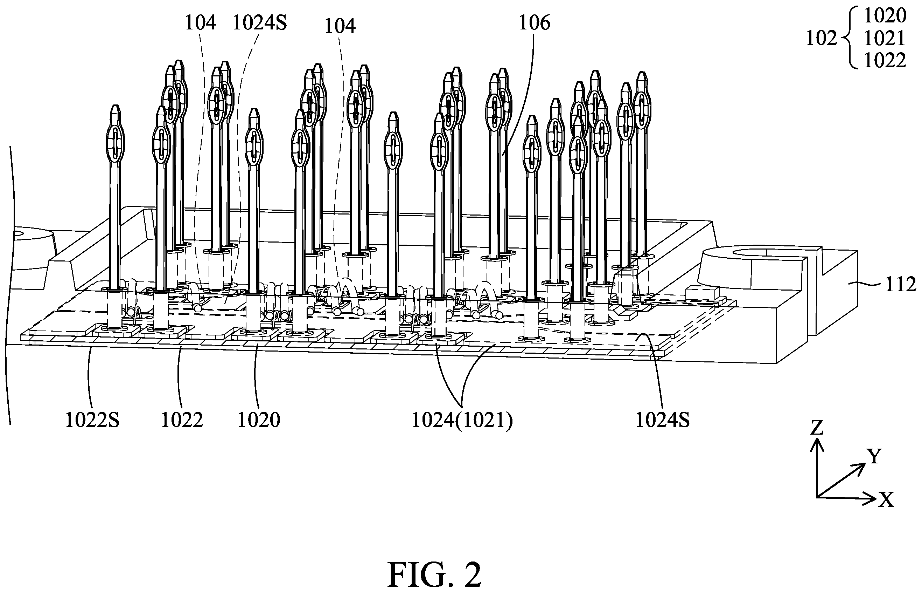

Please refer to FIG. 1 and FIG. 2. FIG. 1 is a three-dimensional schematic diagram of a power module 100 according to an embodiment of the present disclosure, and FIG. 2 is a cross-sectional view of the power module 100 along the line A-A in FIG. 1 according to an embodiment of the present disclosure. In this embodiment, the power module 100 includes a substrate 102, at least one semiconductor component 104, a plurality of pins 106 and a package body 112.

The substrate 102 is, for example, a ceramic substrate, which includes a base 1020, an electrical conductive layer 1021 and a thermal conductive layer 1022. The electrical conductive layer 1021 and the thermal conductive layer 1022 are arranged on opposite sides of the base 1020. The electrical conductive layer 1021 includes a plurality of electrical conductive portions 1024, and each of the electrical conductive portions 1024 has a first metal surface 1024S.

The semiconductor component 104 may be a semiconductor chip, such as a power control chip, but it is not limited thereto. The semiconductor component 104 is disposed on the first metal surface 1024S. Furthermore, the plurality of pins 106 are configured so that the power module 100 can be plugged into an external connector or another electronic device (not shown in the figures). The plurality of pins 106 extend from the first metal surface 1024S, and the pins 106 are configured to be electrically connected to the semiconductor component 104.

In addition, the package body 112 is configured to protect the semiconductor component 104 and the substrate 102. The package body 112 is made of insulating material, such as epoxy resin, but it is not limited thereto. The package body 112 is configured to cover the first metal surface 1024S and the aforementioned semiconductor component 104, and the package body 112 partially encloses each of the pins 106. In addition, the Comparative Tracking Index (CTI) of the package body 112 is greater than 400, but it is not limited thereto. Regarding the CTI value of the package body 112, the industry generally has two types: 400~599 and > 600. The higher the value, the closer the distance between two conductors can be.

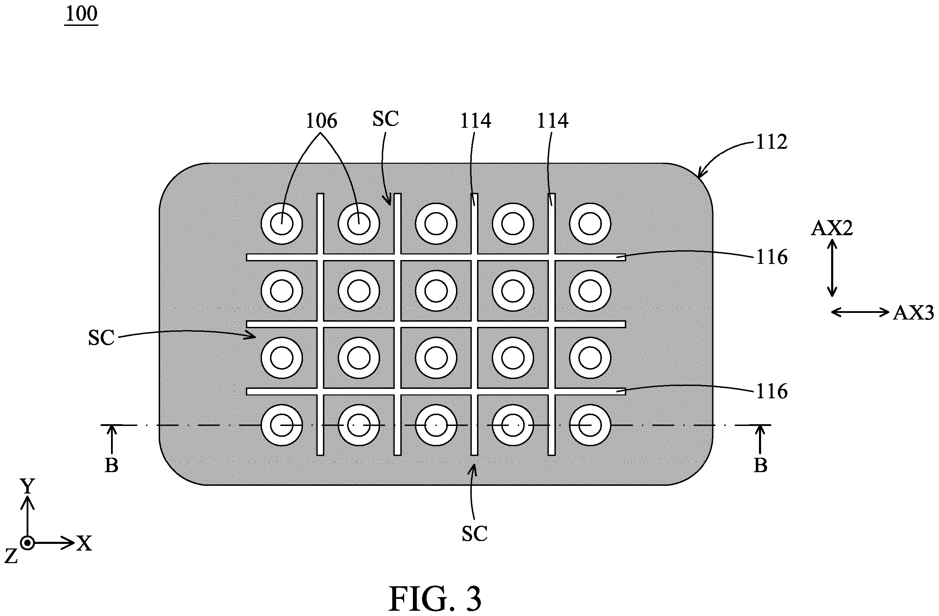

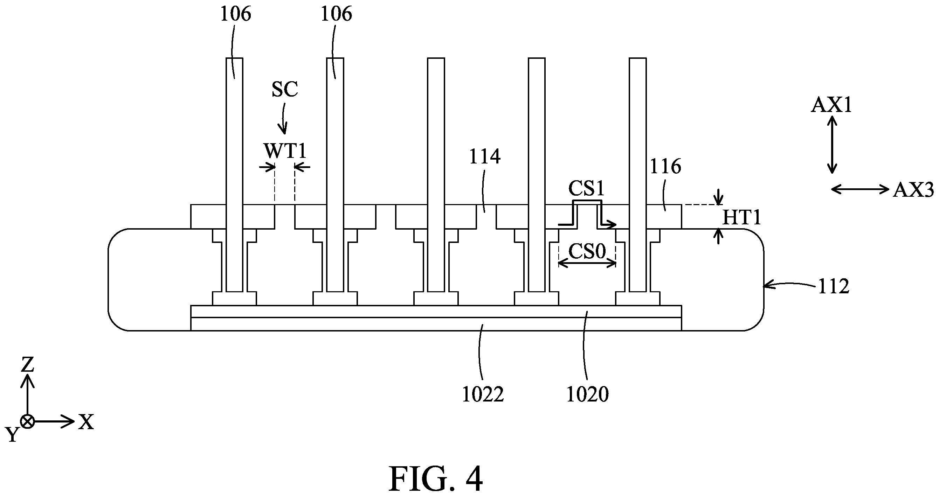

Next, please refer to FIG. 3 and FIG. 4. FIG. 3 is a simplified top view of the power module 100 according to an embodiment of the present disclosure, and FIG. 4 is a cross-sectional view of the power module 100 along line B-B in FIG. 3 according to an embodiment of the present disclosure. As shown in FIG. 3 and FIG. 4, these pins 106 extend along a first axis AX1, and when viewed along the first axis AX1 (the Z-axis), these pins 106 are arranged in a matrix.

Based on the arrangement of these pins 106, the power module 100 can correspond to different types of connectors. Thus, there is no need to design power modules with pins 106 in different arrangements for different types of connectors. Therefore, the cost of production is greatly reduced.

As shown in FIG. 3, there is a gap SC between each two adjacent pins 106, and a separating element can be disposed in the gap SC to increase the creepage distance between two adjacent pins 106. Specifically, when viewed along the first axis AX1, these separating elements may include a plurality of first separating elements 114. Each first separating element 114 has a strip-shaped structure which extends along a second axis AX2, and the second axis AX2 is perpendicular to the first axis AX1.

For example, a total path length CS1 of the arrow in FIG. 4 is the creepage distance between two adjacent pins 106. The total path length CS1 is greater than the horizontal distance CS0 between the two adjacent pins 106 (along a third axis AX3). If the first separating element 114 is not provided, the creepage distance is equal to the horizontal distance CS0, and then the creepage distance may be too small to comply with the safety regulations. Therefore, providing the first separating element 114 can achieve the advantage of increasing the creepage distance.

In addition, when viewed along the first axis AX1, these separating elements may further include a plurality of second separating elements 116. Each second separating element 116 has a strip-shaped structure which extends along the third axis AX3, and the third axis AX3 is perpendicular to the first axis AX1 and the second axis AX2.

As shown in FIG. 3, these first separating elements 114 are connected to the second separating elements 116, and these first separating elements 114 and the second separating elements 116 are staggered with each other.

In this embodiment, as shown in FIG. 4, each of the first separating elements 114 and the second separating elements 116 is a rectangular protruding structure, and the width WT1 of the protruding structure is greater than or equal to 1 mm.

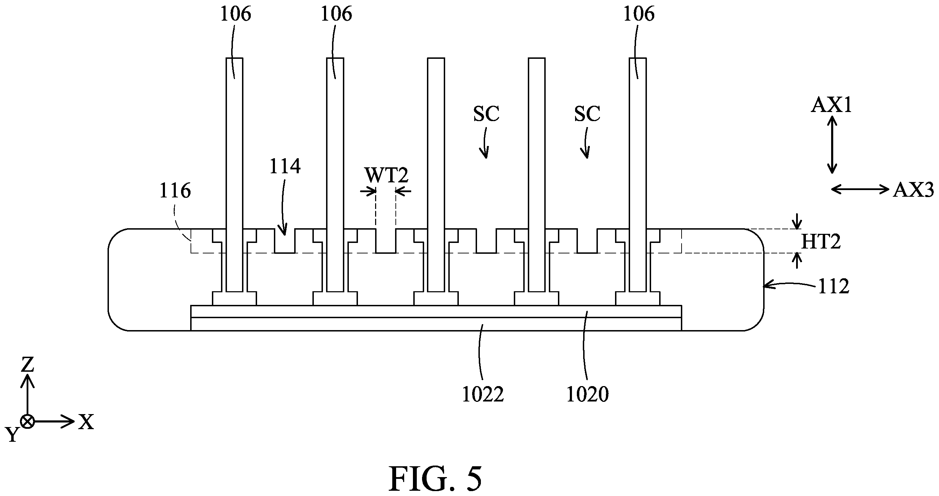

The first separating elements 114 and the second separating elements 116 are not limited to the protruding structures. As shown in FIG. 5 , FIG. 5 is a schematic cross-sectional view of a power module 100 according to another embodiment of the present disclosure. In this embodiment, each of the first separating elements 114 and the second separating elements 116 may be a concave structure, and the width WT2 of the concave structure is greater than or equal to 1 mm.

In addition, it should be noted that in FIG. 4, the height HT 1 of the protruding structure is also greater than or equal to 1 mm. In FIG. 5, the depth HT2 of the concave structure is also greater than or equal to 1 mm. Based on such a structural design, the creepage distance between two adjacent pins 106 can be effectively increased.

Furthermore, in this embodiment, the first separating elements 114, the second separating elements 116 and the package body 112 can be integrally formed as one piece, but they are not limited thereto. In other embodiments, the materials of the first separating elements 114 and the second separating elements 116 may be different from the material of the package body 112. For example, the first separating elements 114 and the second separating elements 116 can be made of elastic materials, and can be fixedly disposed on the package body 112 using glue or tape. The elastic materials may include rubber, for example, but it is not limited thereto.

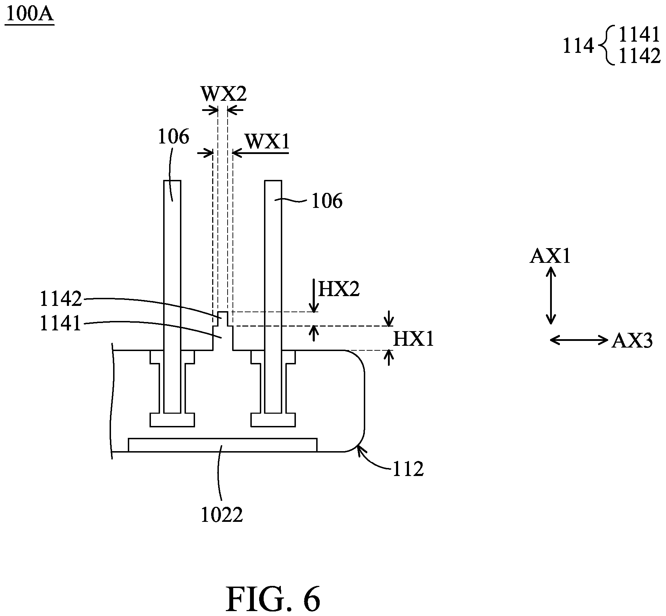

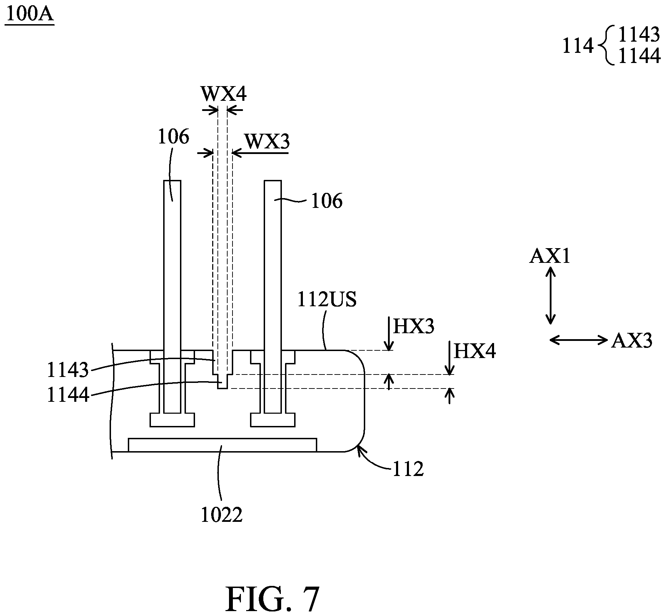

Next, please refer to FIG. 6 and FIG. 7. FIG. 6 and FIG. 7 are schematic cross-sectional views of simplified partial structures of a power module 100A according to different embodiments of the present disclosure. In FIG. 6, the first separating element 114 may have a first protruding structure 1141 and a second protruding structure 1142. The first protruding structure 1141 is disposed on the package body 112, and the second protruding structure 1142 is fixedly disposed on the first protruding structure 1141.

The height HX1 of the first protruding structure 1141 is greater than or equal to 1 mm, and the height HX2 of the second protruding structure 1142 is greater than or equal to 1 mm. Similarly, the width WX1 of the first protruding structure 1141 is greater than or equal to 2 mm, and the width WX2 of the second protruding structure 1142 is greater than or equal to 1 mm.

In FIG. 7, the first separating element 114 has a first concave structure 1143 and a second concave structure 1144. The first concave structure 1143 is recessed along the first axis AX1 from the upper surface 112US of the package body 112, and the second concave structure 1144 is recessed from the first concave structure 1143 along the first axis AX1.

The depth HX3 of the first concave structure 1143 is greater than or equal to 1 mm, and the depth HX4 of the second concave structure 1144 is greater than or equal to 1 mm. Similarly, the width WX3 of the first concave structure 1143 is greater than or equal to 2 mm, and the width WX4 of the second concave structure 1144 is greater than or equal to 1 mm.

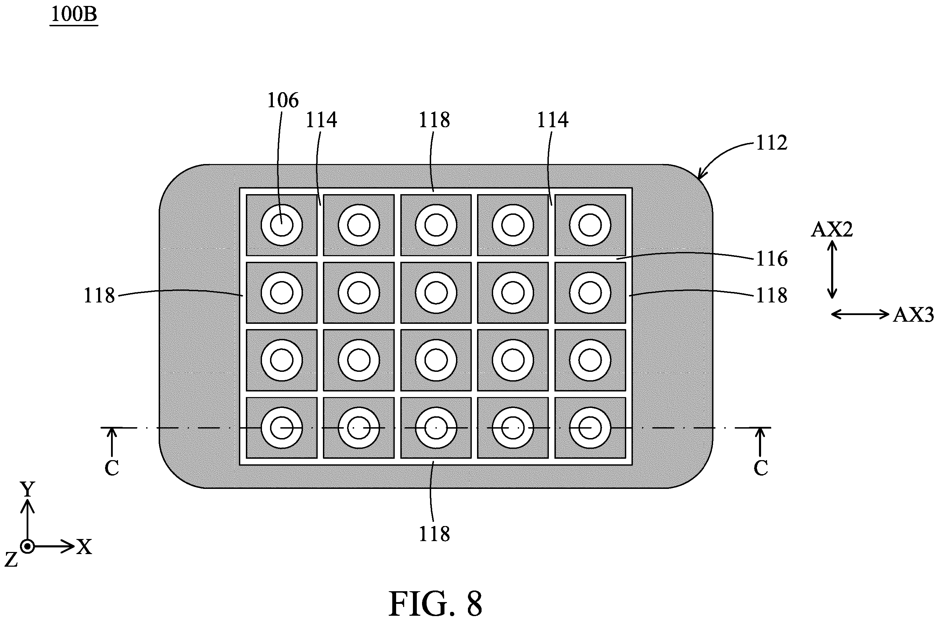

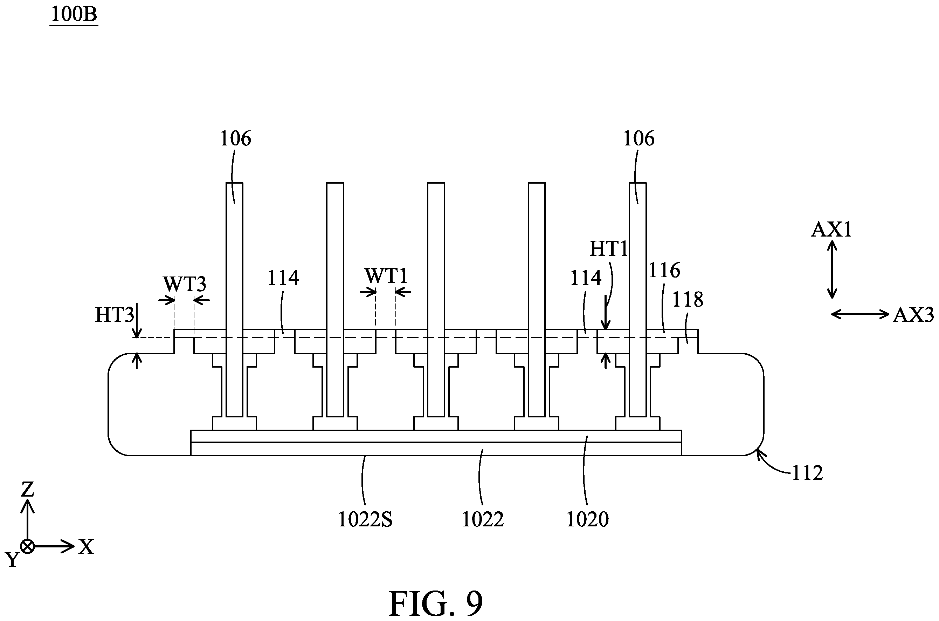

Next, please refer to FIG. 8 and FIG. 9 at the same time. FIG. 8 is a simplified top view of a power module 100B according to another embodiment of the present disclosure, and FIG. 9 is a schematic cross-sectional view of the power module 100B along line segment C-C in FIG. 8 according to another embodiment of the present disclosure. As shown in FIG. 8 and FIG. 9, the package body 112 of the power module 100B can be further provided with four third separating elements 118, and when viewed along the first axis AX1, these four third separating elements 118 form a rectangle which surrounds the pins 106, the first separating elements 114, and the second separating elements 116.

In this embodiment, the four third separating elements 118 are connected to the first separating elements 114 and the second separating elements 116, but they are not limited thereto. In other embodiments, the third separating elements 118 may not be connected to the first separating elements 114 and the second separating elements 116.

In addition, in this embodiment, the first separating elements 114, the second separating elements 116 and the third separating elements 118 may be made of elastic materials, such as rubber material, but they are not limited thereto. That is, the material of the package body 112 is different from the materials of the first separating elements 114 , the second separating elements 116 and the third separating elements 118. In addition, in some embodiments, the first separating elements 114, the second separating elements 116, the third separating elements 118 and the package body 112 may be integrally formed as one piece and made of an elastic material.

As shown in FIG. 9, each of these third separating elements 118 may also be a rectangular protruding structure, and the width WT3 of this protruding structure is greater than or equal to 1 mm. It is worth noting that the heights of the third separating element 118 and the first separating element 114 may be different. In this embodiment, the height HT3 of the third separating element 118 is less than the height HT1 of the first separating element 114, but the height HT3 is greater than or equal to 1 mm.

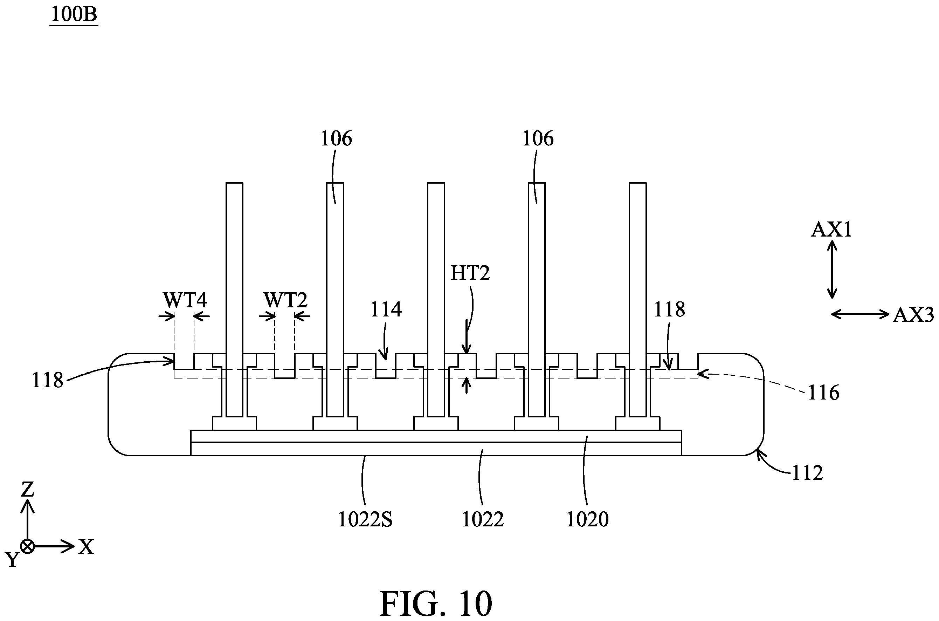

Similarly, the third separating element 118 is not limited to the protruding structure. As shown in FIG. 10, FIG. 10 is a schematic cross-sectional view of the power module 100B according to another embodiment of the present disclosure. In this embodiment, each of the third separating elements 118 is a concave structure, and the width WT4 of each of the third separating elements 118 is greater than or equal to 1 mm. In addition, in FIG. 10, the depth HT4 of the third separating element 118 is smaller than the depth HT2 of the first separating element 114, but the depth HT4 is greater than or equal to 1 mm.

Furthermore, as shown in FIG. 9, FIG. 10 and FIG. 2, the thermal conductive layer 1022 of the substrate 102 has a second metal surface 1022S which is configured to dissipate the heat generated by the power module 100B to the external environment. The first metal surface 1024S and the second metal surface 1022S are located on opposite sides of the substrate 102, and a portion of the second metal surface 1022S is exposed from the package body 112 so as to increase the heat dissipation effect.

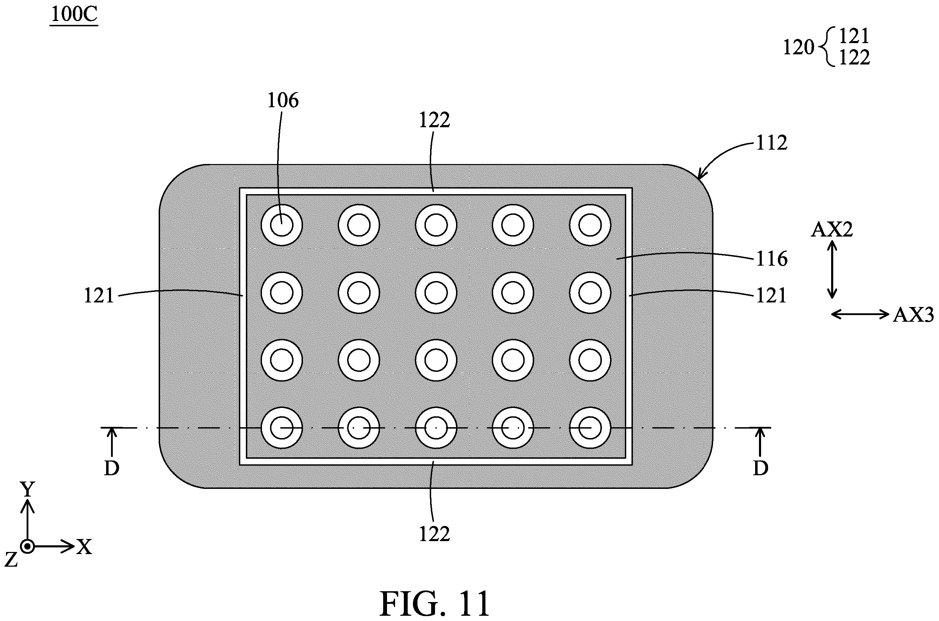

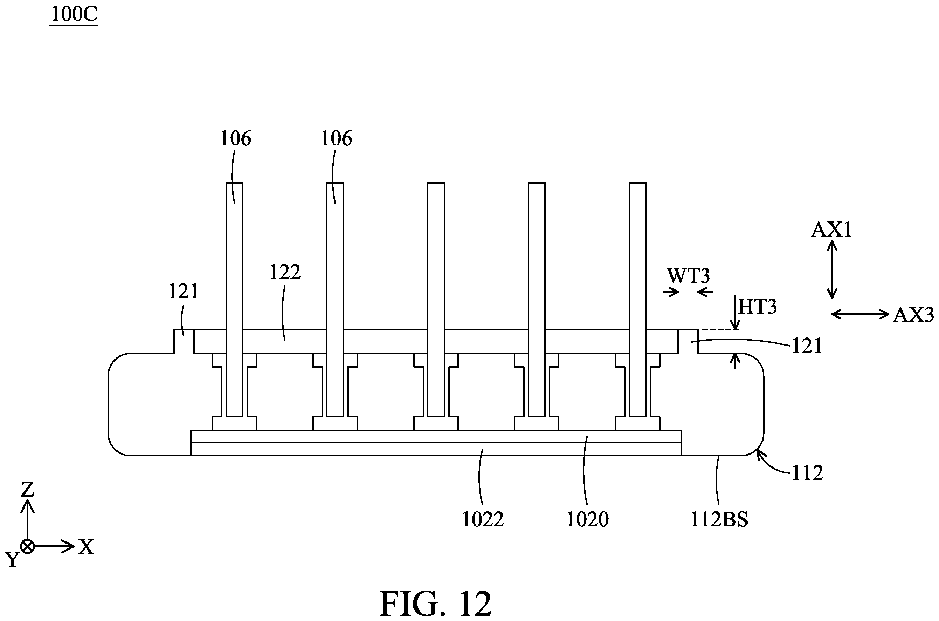

Next, please refer to FIG. 11 and FIG. 12 at the same time. FIG. 11 is a simplified top view of a power module 100C according to another embodiment of the present disclosure, and FIG. 12 is a schematic cross-sectional view of the power module 100C along line D-D in FIG. 11 according to another embodiment of the present disclosure. In this embodiment, the power module 100C includes a first separating element 120 which is disposed on the package body 112 and surrounds the pins 106.

As shown in FIG. 11 and FIG. 12, similar to the previous embodiments, these pins 106 extend along the first axis AX1, and when viewed along the first axis AX1, the first separating element 120 has two first strip-shaped portion 121 and two second strip-shaped portions 122. The two first strip-shaped portions 121 extend along the second axis AX2, and the two second strip-shaped portions 122 extend along the third axis AX3 . The first axis AX1, the second axis AX2 and the third axis AX3 are perpendicular to each other.

In this embodiment, as shown in FIG. 12, the two first strip-shaped portions 121 and the two second strip-shaped portions 122 can be integrally formed as one piece, and each of the first strip-shaped portions 121 and the second strip-shaped portions 122 may be a rectangular protruding structure. The first strip-shaped portions 121 and the second strip-shaped portions 122 are similar to the third separating element 118 in FIG. 9, and may have a height HT3 and a width WT3, both of which are greater than or equal to 1 mm.

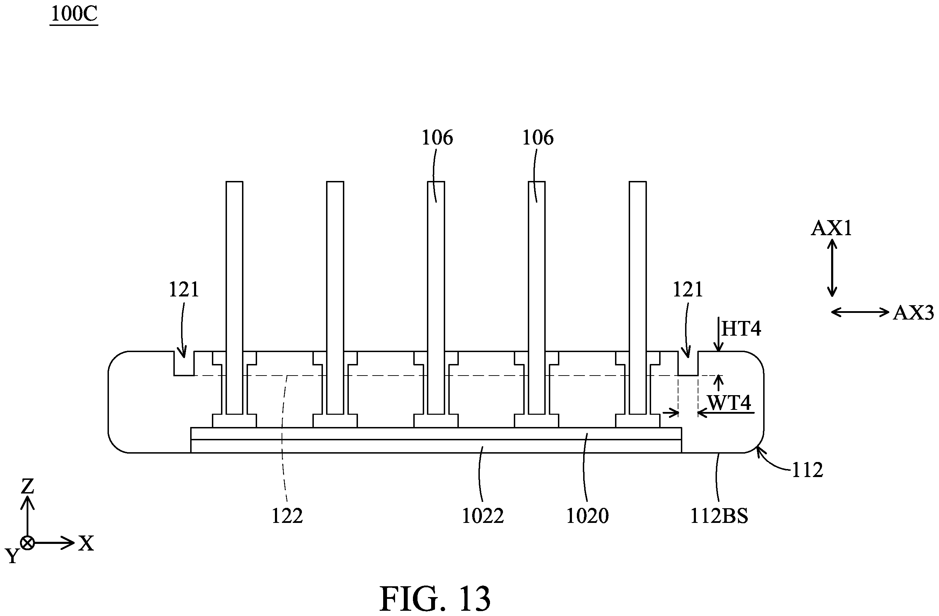

The first strip-shaped portions 121 and the second strip-shaped portions 122 are not limited to the above protruding structures. As shown in FIG. 13, FIG. 13 is a schematic cross-sectional view of the power module 100C according to another embodiment of the present disclosure. In this embodiment, each of the two first strip-shaped portions 121 and the two second strip-shaped portions 122 is a concave structure, similar to the third separating element 118 in FIG. 10, and may have a depth HT4 and a width WT4, both of which are greater than or equal to 1 mm.

Based on the design of the first strip-shaped portions 121 and the second strip-shaped portions 122, the creepage distance between the outermost pin 106 and the bottom surface 112BS of the package body 112 can be effectively increased.

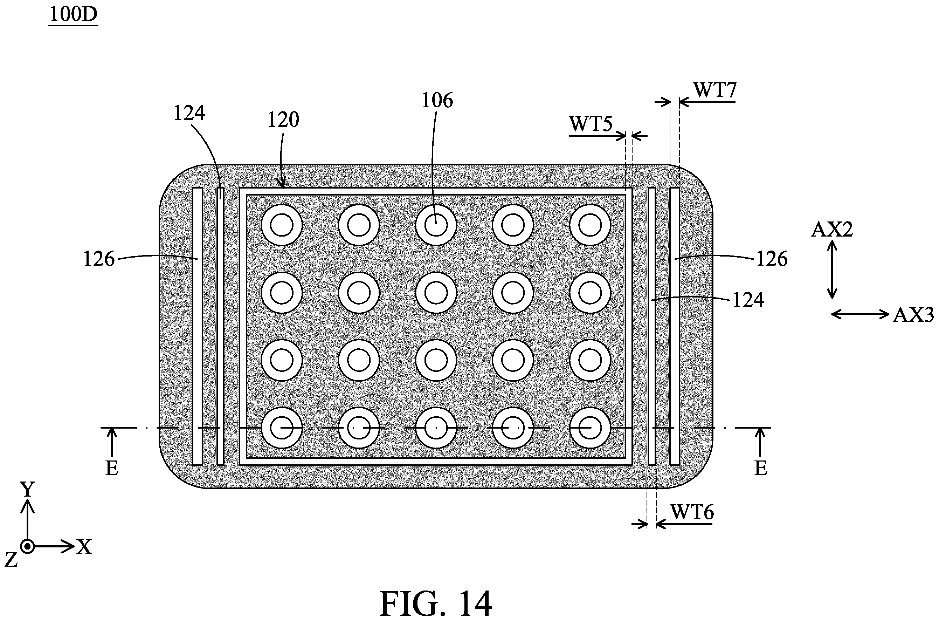

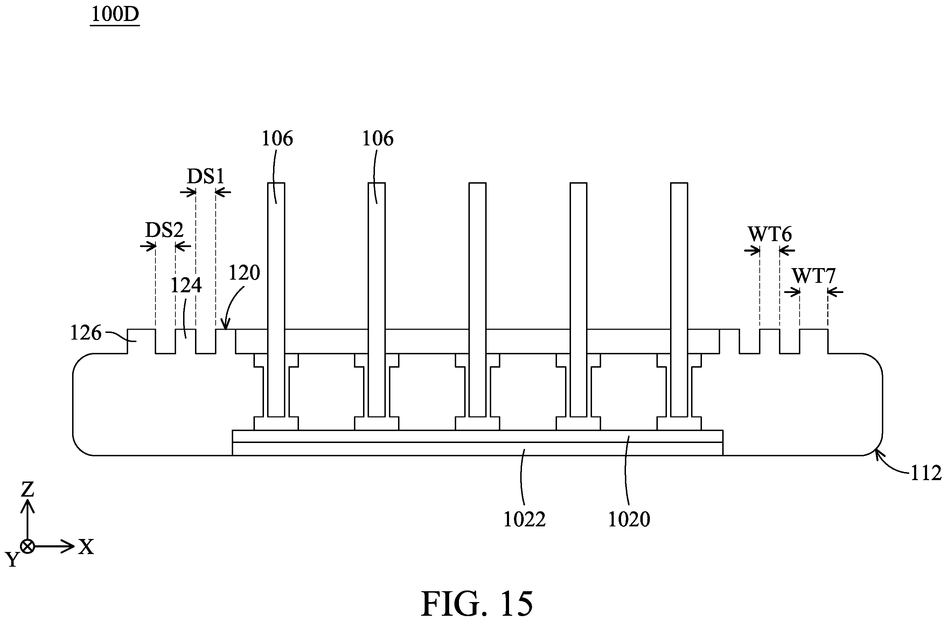

Next, please refer to FIG. 14 and FIG. 15 at the same time. FIG. 14 is a simplified top view of a power module 100D according to another embodiment of the present disclosure, and FIG. 15 is a schematic cross-sectional view of the power module 100D along line E-E in FIG. 14 according to another embodiment of the present disclosure. Compared with the power module 100C, the power module 100D may further include at least a second separating element 124 which is disposed on one side of the first separating element 120, and the second separating element 124 extends along the second axis AX2.

As shown in FIG. 14, the width WT5 of the first separating element 120 and the width WT6 of the second separating element 124 are both greater than 1 mm, and as shown in FIG. 15, the distance DS1 between the second separating element 124 and the first separating element 120 is greater than 1 mm.

In addition, in this embodiment, the power module 100D may further include at least a third separating element 126. The second separating element 124 is located between the first separating element 120 and the third separating element 126, and the third separating element 126 extends along the second axis AX2.

In this embodiment, the width WT7 of the third separating element 126 is greater than 1 mm, and the distance DS2 between the third separating element 126 and the second separating element 124 is greater than 1 mm. In this embodiment, the distance DS2 may be equal to the distance DS1, but it is not limited thereto. In other embodiments, distance DS2 may be greater than distance DS1.

As shown in FIG. 15, each of the second separating elements 124 and the third separating elements 126 may be a protruding structure, and the width WT6 of the second separating element 124 is different from the width WT7 of the third separating element 126. For example, the width WT7 of the third separating element 126 is greater than the width WT6 of the second separating element 124.

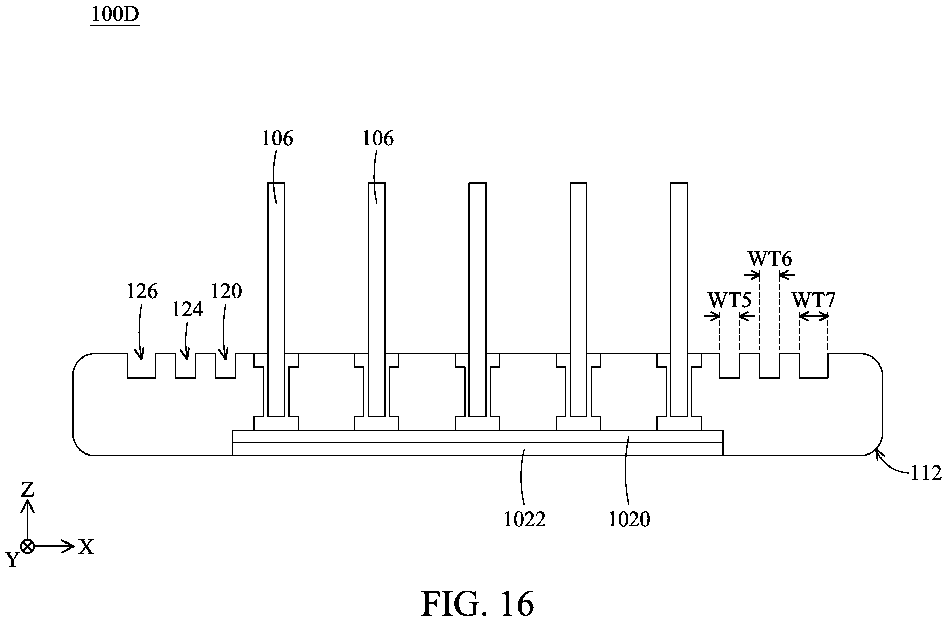

Similarly, the second separating element 124 and the third separating element 126 are not limited to the protruding structures. As shown in FIG. 16, FIG. 16 is a schematic cross-sectional view of the power module 100D according to another embodiment of the present disclosure. In this embodiment, each of the second separating elements 124 and the third separating elements 126 is a concave structure.

Based on the design of the first separating element 120, the second separating element 124 and the third separating element 126, the creepage distance between the outermost pin 106 and the bottom surface of the package body 112 can be effectively increased.

Similar to the previous embodiments, when the first separating element 120, the second separating element 124 and the third separating element 126 are protruding structures, they may be made of elastic materials. Therefore, when the power module 100D is connected to an external connector, the buffering function can be effectively achieved so as to prevent the power module 100D from being damaged by excessive force.

In summary, the present disclosure provides a power module having a substrate 102, a plurality of pins 106 and a package body 112. There is a gap SC between each two adjacent pins 106, and at least one separating element can be disposed in the gap SC to increase the creepage distance between two adjacent pins 106. The separating element can be a protruding structure or a concave structure, and the height and width of the protruding structure or the concave structure are greater than or equal to 1 mm.

Therefore, based on the design of the present disclosure, not only can the power module comply with safety regulations, but also the distance between two adjacent pins 106 can be shortened, thereby reducing the overall size of the power module. In addition, the separating element can be made of elastic materials, so that when the power module is connected to an external connector, the protruding separating element can serve as a buffering portion to prevent the power module from being damaged due to the excessive impact force.

Although the embodiments and their advantages have been described in detail, it should be understood that various changes, substitutions, and alterations can be made herein without departing from the spirit and scope of the embodiments as defined by the appended claims. Moreover, the scope of the present application is not intended to be limited to the particular embodiments of the process, machine, manufacture, composition of matter, means, methods, and steps described in the specification. As one of ordinary skill in the art will readily appreciate from the disclosure, processes, machines, manufacture, compositions of matter, means, methods, or steps, presently existing or later to be developed, that perform substantially the same function or achieve substantially the same result as the corresponding embodiments described herein can be utilized according to the disclosure. Accordingly, the appended claims are intended to include within their scope such processes, machines, manufacture, compositions of matter, means, methods, or steps. In addition, each claim constitutes a separate embodiment, and the combination of various claims and embodiments are within the scope of the disclosure.

## Claims

1. A power module (100), comprising:
a substrate (102), having a first metal surface;
a semiconductor component (104), disposed on the first metal surface;
a plurality of pins (106), extending from the first metal surface and configured to be electrically connected to the semiconductor component; and
a package body (112), configured to cover the first metal surface and the semiconductor component, wherein the package body partially encloses each of the pins,
wherein there is a gap (SC) between each two adjacent pins, and a separating element (114) is disposed in each gap to increase a creepage distance between the two adjacent pins.

2. The power module (100) as claimed in claim 1, wherein the plurality of pins (106) extend along a first axis (AX1), and when viewed along the first axis, the plurality of pins are arranged in a matrix.

3. The power module (100) as claimed in claim 2, wherein when viewed along the first axis, the separating elements include a plurality of first separating elements (114; 120), each of the first separating elements has a strip-shaped structure which extends along a second axis (AX2), and the second axis is perpendicular to the first axis;
wherein when viewed along the first axis, the separating elements further include a plurality of second separating elements (116; 124), each of the second separating elements has a strip-shaped structure which extends along a third axis, and the third axis is perpendicular to the first axis and the second axis.

4. The power module (100) as claimed in claim 3, wherein the first separating elements are connected to the second separating elements, and the first separating elements and the second separating elements are staggered with each other;
wherein each of the first separating elements is a protruding structure or a concave structure, and each of the second separating elements is a protruding structure or a concave structure;
wherein a width of the protruding structure or the concave structure is greater than or equal to 1 mm.

5. The power module (100) as claimed in claim 3 or 4, wherein the package body (112) is further provided with four third separating elements, and when viewed along the first axis, the four third separating elements form a rectangle which surrounds the pins, the first separating elements and the second separating elements.

6. The power module (100) as claimed in claim 5, wherein the first separating elements, the second separating elements and the third separating elements are made of elastic materials, and material of the package body is different from the materials of the first separating elements, the second separating elements and the third separating elements.

7. The power module (100) as claimed in claim 5 or 6, wherein each of the third separating elements is another protruding structure or another concave structure, and a width of each of the third separating elements is greater than or equal to 1 mm.

8. The power module (100) as claimed in one of the preceding claims, wherein the substrate further has a second metal surface configured to dissipate heat generated by the power module to external environment, wherein the first metal surface and the second metal surface are located on opposite sides of the substrate, and a portion of the second metal surface is exposed from the package body.

9. A power module (100; 100C), comprising:
a substrate (102), having a first metal surface;
a semiconductor component (104), disposed on the first metal surface;
a plurality of pins (106), extending from the first metal surface and configured to be electrically connected to the semiconductor component;
a package body (112), configured to cover the first metal surface and the semiconductor component, wherein the package body partially encloses each of the pins; and
a first separating element (120), disposed on the package body (112) and surrounding the pins (106).

10. The power module (100; 100C) as claimed in claim 9, wherein the pins extend along a first axis (AX1), and when viewed along the first axis, the first separating element has two first strip-shaped portions (121) and two second strip-shaped portions (122), the two first strip-shaped portions extend along a second axis (AX2), and the two second strip-shaped portions extend along a third axis (AX3), where the first axis, the second axis and the third axis are perpendicular to each other.

11. The power module (100; 100C) as claimed in claim 10, wherein each of the two first strip-shaped portions and the two second strip-shaped portions is a protruding structure or a concave structure.

12. The power module (100; 100D) as claimed in claim 10 or 11, wherein the power module further includes a second separating element (124) which is disposed on one side of the first separating element, and the second separating element extends along the second axis;
wherein a width (WT5; WT6) of each of the first separating element and each of the second separating element is greater than 1 mm, and a distance between the second separating element and the first separating element is greater than 1 mm;
wherein the power module further includes a third separating element (126), the second separating element is located between the first separating element and the third separating element, and the third separating element extends along the second axis.

13. The power module (100; 100D) as claimed in claim 12, wherein a width (WT7) of the third separating element is greater than 1 mm, and a distance between the third separating element and the second separating element is greater than 1 mm.

14. The power module (100; 100D) as claimed in claim 12 or 13, wherein the second separating element and the third separating element are each a protruding structure or a concave structure, and the width of the second separating element is different from a width of the third separating element.

15. The power module (100; 100C; 100D) as claimed in one of claims 12-14, wherein the first separating element, the second separating element and the third separating element are made of elastic materials.
